# EUROPEAN PATENT SPECIFICATION

(11) **EP 3 146 374 B1**
(45) Date of publication and mention of the grant of the patent: **22.06.2022**
(21) Application number: 15730863.6
(22) Date of filing: 22.05.2015
(51) Int. Cl.: G02B 21/00, G02B 21/24, G02B 21/26, H01J 37/02, H01J 37/22

(54) **METHOD FOR POSITIONING A FOCAL PLANE OF A LIGHT IMAGING DEVICE AND APPARATUS ARRANGED FOR APPLYING SAID METHOD**
VERFAHREN ZUR POSITIONIERUNG EINER FOKALEBENE EINER LICHTABBILDUNGSVORRICHTUNG UND VORRICHTUNG ZUR ANWENDUNG DES BESAGTEN VERFAHRENS
PROCEDE POUR POSITIONNER UN PLAN FOCAL D'UN DISPOSITIF D'IMAGERIE DE LUMIERE, ET APPAREIL CONCU POUR METTRE EN OEUVRE LEDIT PROCEDE

(30) Priority: 23.05.2014 NL 2012874
(43) Date of publication of application: 29.03.2017
(73) Proprietor: DELMIC IP B.V., 2628 EB Delft (NL)
(72) Inventor: NARVAEZ, Angela Carolina, 2600 AA Delft (NL); LIV HAMARAT, Nalan, 2600 AA Delft (NL); KRUIT, Pieter, 2600 AA Delft (NL); HOOGENBOOM, Jacob Pieter, 2600 AA Delft (NL)
(74) Representative: Peters, Sebastian Martinus
(86) International application number: PCT/NL2015/050368
(87) International publication number: WO 2015/178774

(56) References cited:
- GB-A- 2 481 726
- US-A1- 2004 129 858
- US-A1- 2008 073 524
- US-A1- 2012 025 075

## Description

### BACKGROUND

The invention relates to an improvement in a so-called integrated inspection apparatus, featuring the integration of a charged particle system, such as a scanning electron microscope (SEM), and light imaging device, such as light microscope optics. It also relates to an improvement in a so-called cathodoluminescence inspection apparatus featuring the detection of light generated by charged particles, such as electrons, when they are irradiating a suitable sample or substrate.

The improvement in particular relates to extension in functionality of such integrated systems, amongst others towards a new and simplified method of operating and aligning such systems. UK Patent Application GB 2481726 A describes an example of a light condensing unit according to the prior art.

To correlate a light microscope signal with the electron microscope signal or to detect a cathode-luminescence signal, it is of importance that the light microscope is focused on the surface of the sample that is exposed to the electron beam.

It is noted that information obtained from images with light microscopy and electron microscopy is to a large extent complementary. With a light microscope different objects can be seen and inspected in a specimen in different colors, which allows for identification of part or whole of the composition of this specimen. With an electron microscope, all constituents of a specimen can be imaged at very small detail (high resolution), much smaller than with a light microscope, but the ability to identify constituents based on color is absent. Users therefore look for ways to combine the information from both the light optical microscope and electron microscope.

One way of doing so is to try to obtain images from the same area of a specimen with both the light and the electron microscope. This approach is usually denoted as correlative light and electron microscopy or CLEM for short. A very accurate and quick way of doing CLEM, is by using an integrated microscope wherein both types of microscope or parts thereof are to a more or less integrated extend contained in a single apparatus. It should however be noted that with a CLEM measurement the color information is still obtained at much lower resolution than the electron microscope information. It is highly desired to obtain both the structural information and the (color) information about the constituents at the high resolution of the electron microscope.

An alternative way to combine the two types of information in a measurement is by detection of the light that is generated in a specimen during or after electron beam irradiation. This light is usually called cathodoluminescence, or CL for short. CL detection can be done with an integrated microscope as described above, but also CL collection systems, e.g. with a parabolic mirror or with an objective lens, for use in an electron microscope can be used. Such systems are typically aligned on the position where mist CL signal is generated. For CL the resolution in the sample plane (xy) is very high, but for very high resolution in three dimensions (xyz) problems may arise due to the large penetration depth (z- or axial direction) in the sample or the substrate onto which the sample can be mounted. As light is generated in the entire so-called interaction volume (volume into which the electrons penetrate and scatter), there can be a large background signal. For sample features of small detail, i.e. high-(xyz-)resolution features, this background signal from the sample body of the supporting substrate can easily overwhelm the actual CL signal from the features of interest. It is then important to use an electron beam with as low as possible electron energy and to have the detector accurately focused at the feature.

In the following, we will, for the sake of simplicity, refer as light microscope to a light microscope integrated in a charged particle beam apparatus, but also to systems used for detection of CL.

An important difference between working with light and working with charged particles is that light interacts in general much weaker with materials than charged particles. Light may penetrate deep into or even traverse transparent materials, while the penetration depth of charged particles is limited to a very thin surface layer, usually less then 10 µm thick. The electron microscope can thus only extract information from the surface of the sample that is exposed to the beam and the region just underneath this surface. To correlate a light microscope signal with the electron microscope signal or to detect a CL signal, it is therefore of importance that the light microscope is focused on the surface of the sample that is exposed to the electron beam, which is typically not the position with the highest signal intensity.

An aim of the present invention is to provide a method for positioning a focal plane of a light microscope on this surface by utilizing an exposure of the sample or a substrate onto which a sample can be mounted, by a charged particle beam.

It should be noted that the invention also relates to focusing the light microscope onto a surface without the aim of correlated microscopy.

### SUMMARY OF THE INVENTION

According to a first aspect, the present invention provides a method for positioning a focal plane of a light imaging device at a surface of a sample or a substrate onto which the sample can be mounted, wherein the sample or the substrate emits light when irradiated with charged particles, the method comprising the steps as defined in appended claim 1. 11 According to another aspect, the present invention provides a method further comprising the steps as defined in appended claim 2.

The present invention exploits the phenomenon that charged particles do not penetrate deep into the sample. Therefore cathodoluminescence, which results from irradiating a sample with charged particle, originates from this relatively thin surface layer and thus provides a thin, well defined, source of luminescence light. According to the present invention this thin source of luminescence light is used for positioning the focal plane of the light imaging device at the surface of the sample.

On the one hand the method of the present invention is used with a sample which emits luminescence light when it is irradiated with charged particles. However, alternatively or in addition, the present invention proposes to use a substrate which emits luminescence light when it is irradiated with charged particles, in case the sample does not emit luminescence light or in case no sample is present.

According to an aspect of the invention, the method first used a relatively high charged particle energy which yields a relatively high intensity of the luminescence light. This high light intensity is more easy to detect. However when using high charged particle energy the penetration depth of the charged particles is relatively high. For example the penetration depth of an electron beam at a landing energy of 30 keV may be 10 µm. Since the luminescence light originates from the whole interaction volume of the charged particle beam, the maximum intensity of the luminescence light may lay well below the surface of the sample. The positioning of the focal plane of the light imaging device at the maximum intensity of the luminescence light will provide a misalignment with respect to the surface of the sample. By subsequently proceeding with the method at a lower charged particle energy, the luminescence intensity will be lower and more difficult to detect, but this luminescence light originates from a thinner surface layer because the penetration depth of the charged particle beam having the lower energy is less than the penetration depth of the charged particle beam having the high energy. For example the penetration depth of an electron beam at a landing energy of 2 keV may be 100 nm. Accordingly the focus plane can be positioned more precisely at the surface of the sample using a lower charged particle energy.

Accordingly the invention proposes to perform a 'rough' positioning using a relatively high charged particle energy, and subsequently performing a more precise positioning using a lower charged particle energy.

In an embodiment, the steps iv, v and vi, are repeated until the difference between the new focal position and the focal position is equal to or smaller than the threshold value. According to this embodiment, the energy of the charged particles is further reduced each time the method is repeated. Each time the energy of the charged particles is reduced, the penetration depth of the charged particles is reduced and the positioning of the focal plane converges to an optimal position, which is at least substantially at the surface of the sample.

In an embodiment, the focal position is established at the position where a maximum signal of the light intensity is measured. This embodiment is particularly suitable when repeating the steps iv, v and vi and reducing the charged particle energy each time the steps are repeated. Because when arriving at using very low charged particle energies, the charged particle interact substantially with the thin upper surface layer of the sample and the emitted luminescent light originates from this thin upper surface layer. Focusing at the maximum signal of the light intensity using the very low charged particle energies, results in the desired focusing at the thin upper surface layer of the sample. In this case the focus of the optical microscope is at least substantially at the same position where the sample will be observed with the charged particle device, such as an electron microscope.

Alternatively, in an embodiment, the focal position is established at a distance to the position where a maximum signal of the light intensity is measured. For example, the focal position is established by translating the focal plane over a translation distance in the direction towards or away from the sample and/or substrate, from the position where a maximum signal of the light intensity is measured. The method according to this embodiment may be used for samples which substantially do not emit luminescent light when irradiated with charged particles. In this case a luminescent substrate can be used for positioning the focal plane of the light imaging device. In order to position the focal plane at the surface of a sample which is arranged on top of said substrate, the focal plane must be translated over a distance substantially equal to the thickness of the sample.

The same translation may be applied with weakly luminescent samples. For such samples the charged particle beam's energy must be high in order to obtain a detectable amount of luminescent light. As stated above, for charged particle of high energy the penetration dept is relatively large, and the position of the maximum intensity of the emitted luminescent light lies beneath the surface of the sample. In case that the charged particle beam cannot be reduced because the intensity of the luminescent light would become too low to detect, a correction can be made by translating the focal plane over a distance which is preferably equal to the approximate depth of the position of maximum intensity below the sample surface.

According to the invention, the focal position is established spaced apart at a predetermined distance in the direction towards or away from the sample and/ or substrate, with respect to the position where a maximum signal of the light intensity is measured. In an embodiment, said distance is a function of the set charged particle beam energy.

As already discussed above, the positioning of the focal plane of the light imaging device at the maximum intensity of the luminescence light will provide a misalignment with respect to the surface of the sample. However when the amount of misalignment is known, at least approximately, the focal position can be established at a distance to the position where a maximum signal of the light intensity is measured in order to compensate for the misalignment.

The amount of misalignment can, for example, be established using the method according an aspect of the invention, as described above. When the amount of misalignment has been established on one position on a sample, the focal plane can be positioned at other subsequent investigated position using the method according to the invention as described above.

In an embodiment, the focal position is established by translating the focal plane over a translation distance in the direction towards or away from the sample and/or substrate, with respect to the position where a maximum signal of the light intensity is measured.

The further embodiments below, may be applied to the method according to the invention.

In an embodiment, the direction in which the focal plane is translated is determined based on the measure intensity of the light signal as a function of the position of said focal plane with respect to the sample and/or substrate.

In an embodiment, the focal plane of the light imaging device is adjusted while monitoring the intensity of the light signal until a certain value of the light intensity is reached and the focal plane is fixed at this position.

In an embodiment, the charged particle beam scans an area on the sample or the substrate during the measuring of the light signal, and the light signal is taken as the integrated value over the scan of the area.

In an embodiment, the charged particle beam is kept at a stationary position with respect to the sample and/or the substrate, and wherein the electron beam is substantially focused on the sample or the substrate.

Alternatively, in an embodiment, the charged particle beam is kept at a stationary position with respect to the sample and/or the substrate, and wherein the electron beam is not focused at the sample or the substrate.

In an embodiment, at least the lower charge particle beam energy is in a range of 0-5keV, preferably 2keV or lower.

In an embodiment, the method steps are repeated for at least three points around a region of interest on the sample and/or the substrate, and whereby the focal plane positions for these three points are stored and processed to determine the focal plane position at the mentioned region of interest

According to another aspect, the present invention provides an apparatus comprising a light imaging device and charged particle device, wherein the charged particle device is arranged for projecting charged particles onto a sample and/or a substrate onto which the sample can be mounted, wherein the sample or the substrate emits light when irradiated with said charged particles, and wherein the light imaging device is arranged for imaging said emitted light from the sample or the substrate, wherein the apparatus comprises a positioning system which is arranged for positioning a focal plane of the light imaging device with respect to the sample and/or the substrate, and wherein the positioning system comprises a control device which comprises a computer program comprising instructions for positioning the focal plane of the light imaging device at the surface of the sample or the substrate using the above described method or an embodiment thereof.

According to another aspect, the present invention provides a computer program comprising instructions which, when loaded onto a computer device or control device, are adapted to perform a method as described above or an embodiment thereof.

According to another aspect, the present invention provides a computer readable medium, having a computer program as described above recorded thereon.

The various aspects and features described and shown in the specification can be applied, individually, wherever possible. These individual aspects, in particular the aspects and features described in the attached dependent claims, can be made subject of divisional patent applications.

### BRIEF DESCRIPTION OF THE DRAWINGS

The invention will be elucidated on the basis of an exemplary embodiment shown in the attached drawings, in which:
Figures 1 and 2 schematically show an apparatus comprising a light imaging device and charged particle device,
Figure 3 schematically indicates the interaction volume of the charged particles with a charged particle beam having a high energy,
Figure 4 schematically indicates the interaction volume of the charged particles with a charged particle beam having a lower energy,
Figure 5 schematically depicts the intensity of the cathodoluminescence as a function of the z position of the focal plane,
Figure 6 schematically shows an embodiment wherein the charged particle beam scans an area on the sample or the substrate,
Figure 7 schematically shows an embodiment wherein the method steps are repeated for at least three points around a region of interest,
Figure 8 schematically shows a flow diagram of a first example of a method according to the present invention, and
Figure 9 schematically shows a flow diagram of a second example of a method according to the present invention.

### DETAILED DESCRIPTION OF THE INVENTION

An apparatus according to the present invention comprises a light imaging device 1 and charged particle device 2. The charged particle device 2 is arranged for projecting a charged particle beam 3 onto a sample 4 and/or a substrate 5 onto which the sample 4 can be mounted. The sample 4 or the substrate 5 emits light when irradiated with charged particles from said charged particle beam 3. The light imaging device 1 is arranged for collecting at least a part of said emitted light 6 and for imaging said emitted light 6 from the sample 4 or the substrate 6.

The apparatus comprises a positioning system 9 which is arranged for positioning a focal plane 8 of the light imaging device 1 with respect to the sample 4 and/or the substrate 5. The positioning system 9 is arranged for moving the light imaging device 1 substantially along the optical axis 11 towards and away from the sample 4 and/or the substrate 5, and for positioning the focal plane 8 at a position z along the optical axis 11.

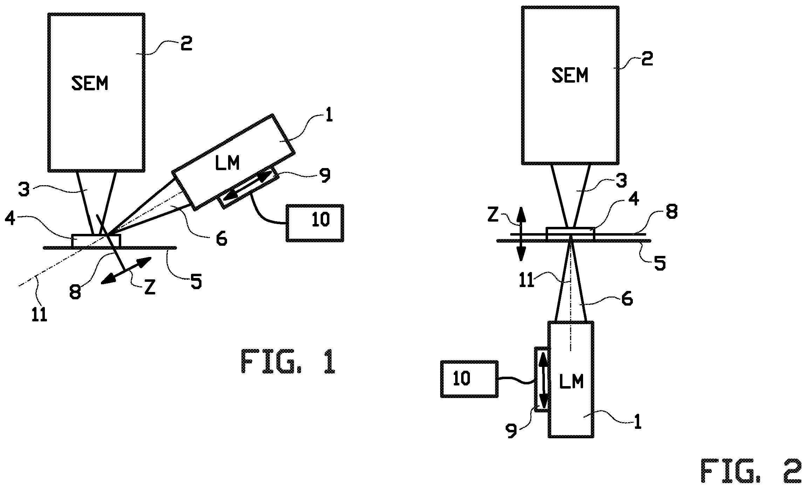

It is noted that the light imaging device 1 can be arranged at a side of the sample 4 and/or substrate 5 which faces towards the charged particle device 2, as shown schematically in figure 1. Alternatively, the light imaging device 1 can be arranged at an opposite side of the sample 4 and/or substrate 5 which faces away from the charged particle device 2, as shown schematically in figure 2.

The positioning system 9 comprises a control device 10 which comprises a computer program comprising instructions for positioning the focal plane 8 of the light imaging device 1 at the surface of the sample 4 or the substrate 5 using a method as described in more detail below.

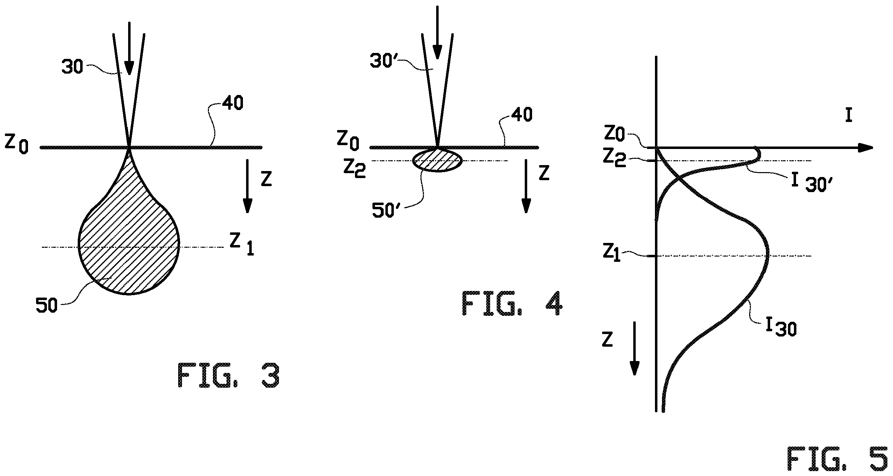

The method of the present invention uses the fact that cathodoluminescence is almost always excited in a sample or sample substrate 40 when exposed to a charged particle beam 30, 30'. This cathodoluminescence originates from the entire interaction volume 50, 50' of the charged particles. The depth of this interaction volume 50, 50' is depended on the energy of the charged particles of the charged particle beam 30, 30'. Figure 3 schematically indicates the interaction volume 50 of the charged particles with a charged particle beam 30 having a high energy. Figure 4 schematically indicates the interaction volume 50' of the charged particles with a charged particle beam 30' having a lower energy. So, in principle, with a low energy charged particle beam 30', the cathodoluminescence originates from near the surface of the sample or sample substrate 40, and focusing the light microscope on this cathodoluminescence signal then leads to the desired focal position.

However, this can be very hard because the cathodoluminescence signal from a low energy beam 30' can be quite low and thus hard to pick up for an out-of-focus light microscope. The intensity of the cathodoluminescence signal is depended on charged particle energy and the beam current. In general for higher charged particle energy, we have a stronger signal originating from a larger volume 50, and cathodoluminescence intensity I₃₀ is at maximum at a depth z₁ as indicated in figure 5. For lower charged particle energy, we have a weaker signal originating from a smaller volume 50', and cathodoluminescence intensity I_{30'} is at maximum at a depth z₂ as indicated in figure 5.

The distance between the actual surface z₀ and z₁ is larger than the distance between the actual surface z₀ and z₂. Thus the position z₁ of maximum cathodoluminescence intensity I is further off from the desired focal plane position at the surface z₀.

According to the method of the present invention, a charged particle beam 3, in particular with a high energy charged particle beam, is used for a 'coarse' alignment of the focal plane 8 of the light imaging device 1 at the surface of a sample 4 or substrate 5: The cathode-luminescence is monitored as a function of focal plane position in the z direction along the light optical axis 11, and to arranged the focal plane 8 at the position z₁ along the optical axis 11 with the maximum cathode-luminescence signal, which is at a z position below the sample surface z₀.

In an embodiment of the present invention, the alignment can be 'refined' by lowering the charged particle energy and again performing the method as indicated above. the z-position z₂ for maximum cathodoluminescence intensity shifts towards the surface z₀.

In an embodiment, the desired focal position at the surface z₀ can be approached by an iterative procedure wherein the charged particle energy is lowered and the method described above is repeated at each iteration. The iterations are, for example, repeated until the difference between the new focal position and the focal position of the previous iteration is equal to or smaller than a predetermined threshold value.

It should be noted that for this focusing method, the electron beam 3 need not be focused at the sample or substrate 40. Charged particle interaction always starts from the surface layer exposed to the charged particle beam. In fact, it can be beneficial to use an unfocused beam, because then the charged particle beam need not be refocused when the charged particle energy is changed.

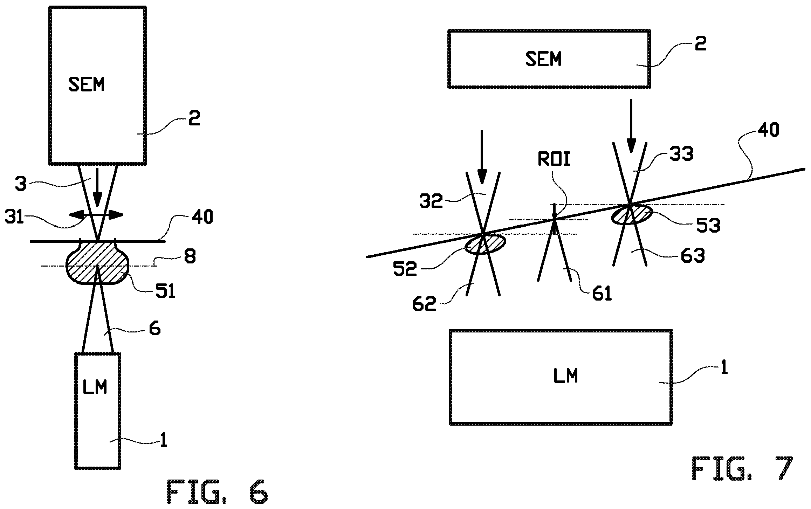

Also, to facilitate the method, in an embodiment the electron beam 3 is scanned 31 over the surface 40, as schematically depicted in figure 6. This does not influence the z-position for maximum cathodoluminescence, but the increased lateral extent of the illuminated area can make focusing easier as the method is then substantially insensitive to lateral shifts of the charged particle beam position.

On the other hand, it can also be preferred to use the method with the charged particle beam 3 at a stationary position, focused at the surface 40. In this case refocusing of the charged particle beam might need to be done after changing charged particle energy, but it has the advantage that the light imaging device 1 can be accurately focused to a position in the focal plane. In a further extension of the method as schematically shown in figure 7, focusing can be performed for at least three positions around a region of interest ROI on a surface 40 to determine the focal plane position in the region of interest ROI. In this case the charged particle beam 32, 33, is positioned subsequently at three positions on the surface 40 around the region of interest ROI. At each position cathodoluminescence 52, 53 creates light 62, 63 which is collected by the light imaging device 1 and which is used for positioning the focus plane of the light imaging device 1 as described in more detail above. From these three positions the focus plane of the light imaging device 1 at the region of interest ROI can be established and the light imaging device 1 can be arranged to detect any light 61 coming from the surface 40 at the region of interest ROI.

In another embodiment, it may not be necessary to look for the z-position at which cathodoluminescence intensity is at maximum, or even to make the iterations at lower energy. If the cathodoluminescence signal profile I₃₀, I_{30'}, as for example shown in figure 5, is well characterized for the material that is being used and can be reproducibly measured, it is possible to position the focal plane of the light imaging device 1 directly on a specific z position in the cathodoluminescence signal profile I₃₀, I_{30'}.

Alternatively, the focal plane position can be achieved by translating a fixed distance d from the position z₁ with the measured maximum of the cathodoluminescence signal profile I₃₀. The direction in which this distance is being moved can be determined from the measured cathodoluminescence profile.

In yet another embodiment, it may not even be needed to measure the entire cathodoluminescence profile. When it is known from which direction (upward or downward) the surface is approached when focusing, or when this direction can be established from the initial shape of the cathodoluminescence profile, the focusing procedure can be stopped once a specific value for the cathodoluminescence intensity has been reached.

The method of the present invention can for example suitable be used in an apparatus which combines a scanning electron microscope SEM and a light microscope LM.

When using cathodoluminescence for characterizing the surface of a material with strong emission or with a nanostructure on top, intensity is detected not only at the spot where the electron beam is focused, but along all the interaction volume, as discussed above. At low electron energies (below 5kV), cathodoluminescence signals can be weak, making it hard to place the objective lens into the focus position, where the emission collection is optimized. Therefore a strategy is needed to match the objective lens focus to that of the electron beam. Wide field imaging or other light microscopy techniques are not always available, or the surface may not give enough contrast. Also, a nanostructure may be too small to find it in an optical image. In addition, in a cathodoluminescence microscopy setup it may be beneficial to have a focusing procedure involving only detection of cathodoluminescence signals. The present invention presents a method that takes advantage of the dependence of the electron interaction volume on the acceleration voltage of the primary electron beam, and of the fact that at low energies the electron range, although it is material dependent, is confined to a couple of tens of nanometers below the sample surface. The process starts by measuring the cathodoluminescence intensity with a high energy electron beam, since then the electron range is larger, cathodoluminescence intensity is higher, and it is thus easier to find a position where the objective lens detects some portion of the cathode-luminescence signal. To focus the objective lens at the sample surface where the structure of interest is located, the following procedure can be applied:
1. Use a high energy electron beam to achieve detection of the cathodoluminescence signal: scan with the electron beam a small area (or spot) in the region of interest while detecting the cathodoluminescence intensity. Translate at least the objective lens of the light microscope in the axial direction (z), until some signal level is detected. The axial intensity distribution can be then obtained by registering the cathodoluminescence intensity while translating the sample or at least the objective lens of the light microscope along this axial direction. Finally, position at least the objective lens of the light microscope at the z point of maximum intensity.
2. Lower the electron beam acceleration voltage and repeat step 1. Continue making consecutive steps of reducing the acceleration voltage and translating the objective lens to the maximum intensity distribution position. The voltage intervals should be small enough so that some cathodoluminescence is always detected.
3. At a sufficiently low acceleration voltage the interaction volume is small enough so that at least the objective lens of the light microscope is focused on the surface or structure of interest.

We have seen at 2kV the electron range for an ITO substrate is 40nm. If the aim is to image confocal cathodoluminescence at high energies, then the acceleration voltage can be switched back to the required value while keeping the objective lens and sample fixed at the position found in the last step.

If a sample bleaches rapidly, that is the intensity of the cathodoluminescence signal decreases due to bleaching of the chromophores, it is recommended to preexpose the sample, increase the scanning speed and integrate the cathodoluminescence signal over a small area rather than in a spot to reduce the charged particle dose.

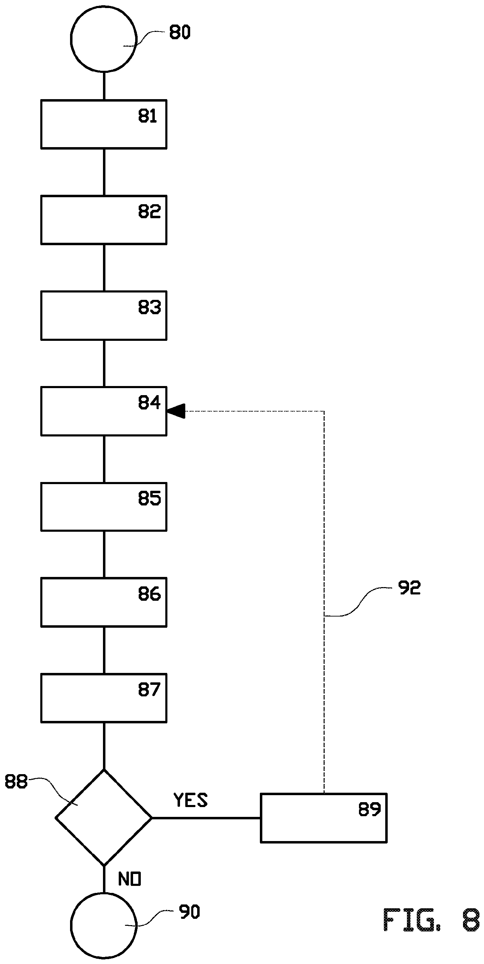

Figure 8 schematically shows a flow diagram of a first example of a method for positioning a focal plane of a light imaging device at a surface of a sample or a substrate onto which the sample can be mounted. The sample or the substrate emits light when irradiated with charged particles. After starting 80 the method, the following steps are subsequently performed:
81. A light, signal which is detectable with the light imaging device, is created by illuminating the sample and/or the substrate with a charged particle beam having a set charged particle beam energy;
82. The focal plane of the light imaging device is moved at least in a direction towards or away from the sample and/or substrate, and an intensity of the light signal is measured as a function of the position of said focal plane with respect to the sample and/or substrate;
83. The focal plane is set at a focal position with respect to the sample and/or the substrate, wherein said focal position is determined using the measured dependence of the intensity of the light signal as a function of the position of said focal plane with respect to the sample and/or substrate using the set charged particle energy;
84. The charged particle beam energy is reduced to a lower charged particle beam energy, while keeping the focal plane at the focal position;
85. The focal plane of the light imaging device is moved at least in a direction towards or away from the sample and/or substrate, and the intensity of the light signal is measured as a function of the position of said focal plane with respect to the sample and/or substrate; and
86. The measured dependence of the intensity of the light signal as a function of the position of said focal plane with respect to the sample and/or substrate at said lower charged particle beam energy is used to determine a new focal position again;
87. Determine the difference between the new focal position and the previous focal position;
88. Is the difference larger than a threshold value;
89. If the answer to the question 88 is YES, adjust the focal position to the new focal position; and
90 If the answer to the question 88 is NO, the focal position is not adjusted, and the method is ended 91.

Although the method can also end after step 89. However in an embodiment, the method is continued by going back 92 to the step 84 in which the charged particle beam energy is reduced to a lower charged particle beam energy, while keeping the focal plane at the adjusted focal position.

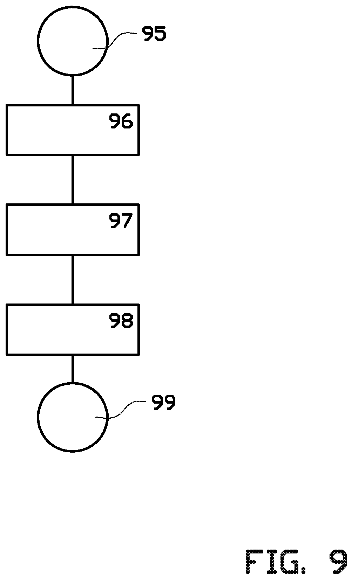

Figure 9 schematically shows a flow diagram of a second example of a method for positioning a focal plane of a light imaging device at a surface of a sample or a substrate onto which the sample can be mounted. The sample or the substrate emits light when irradiated with charged particles. After starting 95 the method, the following steps are subsequently performed:
96. A light signal, which is detectable with the light imaging device, is created by illuminating the sample and/or the substrate with a charged particle beam having a set charged particle beam energy;
97. The focal plane of the light imaging device is moved at least in a direction towards or away from the sample and/or substrate, and an intensity of the light signal is measured as a function of the position of said focal plane with respect to the sample and/or substrate;
98. The focal plane is set at a focal position with respect to the sample and/or the substrate, wherein said focal position is determined using the measured dependence of the intensity of the light signal as a function of the position of said focal plane with respect to the sample and/or substrate using the set charged particle energy, wherein the focal position is established at a predetermined distance in the direction towards or away from the sample and/or substrate, with respect to the position where a maximum signal of the light intensity is measured, and the method is ended 99.

Preferably, said predetermined distance is a function of the set charged particle beam energy. The predetermined distance can, for example, be determined by evaluating the results of the method of figure 8. When in the method of figure 8, the focal plane is positioned at the position where the maximum signal of light intensity is measured, a relation between the position of the maximum single of light intensity with respect to the set charged particle beam energy can be established. This relation can then be used to establish the distance between the position of maximum signal using a relatively high set charged particle beam energy and the position of maximum signal using a low charged particle beam energy, which distance can be used as the predetermined distance mentioned above.

It is to be understood that the above description is included to illustrate the operation of the preferred embodiments and is not meant to limit the scope of the invention. From the above discussion, many variations will be apparent to one skilled in the art that would yet be encompassed by the scope of the present invention as defined in the appended claims.

## Claims

1. Method for positioning a focal plane of a light imaging device at a surface of a sample or a substrate onto which the sample can be mounted, wherein the sample or the substrate emits light when irradiated with charged particles, the method comprising the steps of:
i. creating a light signal detectable with the light imaging device by illuminating the sample and/or the substrate with a charged particle beam having a set charged particle beam energy;
ii. moving the focal plane of the light imaging device at least in a direction towards or away from the sample and/or substrate and measuring an intensity of the light signal as a function of the position of said focal plane with respect to the sample and/or substrate;
iii. setting the focal plane at a focal position with respect to the sample and/or the substrate, said focal position being determined using the measured dependence of the intensity of the light signal as a function of the position of said focal plane with respect to the sample and/or substrate using the set charged particle energy,
**characterized in that** the focal position is established spaced apart at a predetermined distance in the direction towards or away from the sample and/or substrate, with respect to the position where a maximum signal of the light intensity is measured.

2. Method according to the preamble of claim 1, **characterized in that** the method further comprises the steps of:
iv. lowering the charged particle beam energy to a lower charged particle beam energy, while keeping the focal plane at the focal position;
v. moving the focal plane of the light imaging device at least in a direction towards or away from the sample and/or substrate and measuring the intensity of the light signal as a function of the position of said focal plane with respect to the sample and/or substrate; and
vi. using the measured dependence of the intensity of the light signal as a function of the position of said focal plane with respect to the sample and/or substrate at said lower charged particle beam energy to determine a new focal position, and when a difference between this new focal position and the focal position is larger than a threshold value, and the new focal position is spaced apart at a distance in the direction towards or away from the sample and/or substrate with respect to the focal position, the focal position is adjusted to the new focal position.

3. Method according to claim 2, wherein the steps iv, v and vi, are repeated until the difference between the new focal position and the focal position is equal to or smaller than the threshold value.

4. Method according to claim 2 or 3, wherein the focal position is established at the position where a maximum signal of the light intensity is measured.

5. Method according to claim 2 or 3, wherein the focal position is established at a distance in the direction towards or away from the sample and/or substrate, with respect to the position where a maximum signal of the light intensity is measured.

6. Method according to claim 1, wherein said predetermined distance is a function of the set charged particle beam energy.

7. Method according to claim 1, 5 or 6, wherein the focal position is established at said predetermined distance by translating the focal plane a translation distance from the position where a maximum signal of the light intensity is measured, preferably wherein the direction in which the focal plane is translated is determined based on the measured intensity of the light signal as a function of the position of said focal plane with respect to the sample and/or substrate.

8. Method according to claim 2 or 3, wherein the focal plane of the light imaging device is adjusted while monitoring the intensity of the light signal until a certain value of the light intensity is reached and the focal plane is fixed at this position.

9. Method according to any one of the claims 1-8, wherein the charged particle beam scans an area on the sample or the substrate during the measuring of the light signal, and the light signal is taken as the integrated value over the scan of the area.

10. Method according to any one of the claims 1-8, wherein the charged particle beam is kept at a stationary position with respect to the sample and/or the substrate, and wherein the charged particle beam is substantially focused on the sample or the substrate or wherein the charged particle beam is not focused at the sample or the substrate.

11. Method according to claim 2 or any one of claims 3-10 when dependent on claim 2, wherein at least the lower charge particle beam energy is in a range of 0-5 keV, preferably 2keV or lower.

12. Method according to any one of the claims 1-11, wherein the method steps are repeated for at least three points around a region of interest on the sample and/or the substrate, and whereby the focal plane positions for these three points are stored and processed to determine the focal plane position at the mentioned region of interest.

13. Apparatus comprising a light imaging device (1) and charged particle device (2), wherein the charged particle device is arranged for projecting a charged particle beam onto a sample (4) and/or a substrate (5) onto which the sample can be mounted, wherein the sample or the substrate emits light when irradiated with said charged particles, and wherein the light imaging device is arranged for imaging said emitted light from the sample or the substrate, wherein the apparatus comprises a positioning system (9) which is arranged for positioning a focal plane (8) of the light imaging device with respect to the sample and/or the substrate, and wherein the positioning system comprises a control device (10) which comprises a computer program comprising instructions for positioning the focal plane of the light imaging device at the surface of the sample or the substrate using a method according to any one of the preceding claims.

14. A computer program comprising instructions which, when loaded onto the apparatus of claim 13, will cause said apparatus to perform a method according to any one of the claims 1 to 12.

15. A computer readable medium, having a computer program according to claim 14 recorded thereon.

## Patentansprüche

1. Verfahren zum Positionieren einer Brennebene eines lichtbildgebenden Geräts auf einer Oberfläche einer Probe oder eines Substrats, auf dem die Probe befestigt werden kann, wobei die Probe oder das Substrat bei Bestrahlung mit Ladungsteilchen Licht emittiert, wobei das Verfahren die folgenden Schritte umfasst:
i. Erzeugen eines Lichtsignals, das mit dem lichtbildgebenden Gerät detektierbar ist, durch Beleuchten der Probe und/oder des Substrats mit einem Ladungsteilchenstrahl mit einer eingestellten Energie des Ladungsteilchenstrahls;
ii. Bewegen der Brennebene des lichtbildgebenden Geräts zumindest in eine Richtung auf die Probe und/oder das Substrat zu oder von ihr weg und Messen einer Intensität des Lichtsignals als Funktion der Position der Brennebene in Bezug auf die Probe und/oder das Substrat;
iii. Einstellen der Brennebene auf eine Brennpunktposition in Bezug auf die Probe und/oder das Substrat, wobei die Brennpunktposition unter Verwendung der gemessenen Abhängigkeit der Intensität des Lichtsignals als Funktion der Position der Brennebene in Bezug auf die Probe und/oder das Substrat unter Verwendung der eingestellten Energie der Ladungsteilchen bestimmt wird,
**dadurch gekennzeichnet, dass** die Brennpunktposition in einem vorbestimmten Abstand in der Richtung auf die Probe und/oder das Substrat zu oder von ihr weg in Bezug auf die Position, an der ein maximales Signal der Lichtintensität gemessen wird, festgelegt wird.

2. Verfahren nach dem Oberbegriff von Anspruch 1, **dadurch gekennzeichnet, dass** das Verfahren ferner die folgenden Schritte umfasst:
iv. Absenken der Energie des Ladungsteilchenstrahles auf eine niedrigere Energie des Ladungsteilchenstrahles, wobei die Brennebene an der Brennpunktposition gehalten wird;
v. Bewegen der Brennebene des lichtbildgebenden Geräts zumindest in eine Richtung auf die Probe und/oder dem Substrat zu oder van ihr weg und Messen der Intensität des Lichtsignals als Funktion der Position der Brennebene in Bezug auf die Probe und/oder das Substrat; und
vi. Verwenden der gemessenen Abhängigkeit der Intensität des Lichtsignals als Funktion der Position der Brennebene in Bezug auf die Probe und/oder das Substrat bei der niedrigeren Energie des Ladungsteilchenstrahls, um eine neue Brennpunktposition zu bestimmen, und wenn eine Differenz zwischen dieser neuen Brennpunktposition und der Brennpunktposition größer als ein Schwellenwert ist und die neue Brennpunktposition in Bezug auf die Brennpunktposition in der Richtung auf die Probe und/oder das Substrat zu oder von ihr weg beabstandet ist, wird die Brennpunktposition an die neue Brennpunktposition angepasst.

3. Verfahren nach Anspruch 2, wobei die Schritte iv, v und vi wiederholt werden, bis die Differenz zwischen der neuen Brennpunktposition und der Brennpunktposition gleich oder kleiner als der Schwellenwert ist.

4. Verfahren nach Anspruch 2 oder 3, wobei die Brennpunktposition an der Stelle festgelegt wird, an der ein maximales Signal der Lichtintensität gemessen wird.

5. Verfahren nach Anspruch 2 oder 3, wobei die Brennpunktposition in Bezug auf die Position, an der ein maximales Signal der Lichtintensität gemessen wird, in einem Abstand in Richtung auf die Probe und/oder das Substrat zu oder davon weg festgelegt wird.

6. Verfahren nach Anspruch 1, wobei der vorbestimmte Abstand eine Funktion der eingestellten Energie des Ladungsteilchenstrahls ist.

7. Verfahren nach Anspruch 1, 5 oder 6, wobei die Brennpunktposition durch Verschieben der Brennebene um eine vorbestimmte Verschiebungsdistanz von der Position, in der ein maximales Signal der Lichtintensität gemessen wird, entfernt wird, vorzugsweise wobei die Brennebene um die gemessene Intensität des Lichtsignals in Abhängigkeit von der Position der Brennebene in Bezug auf die Probe und/oder das Substrat verschoben wird.

8. Verfahren nach Anspruch 2 oder 3, wobei die Brennebene des lichtbildgebenden Geräts unter Überwachung der Intensität des Lichtsignals angepasst wird, bis ein bestimmter Wert der Lichtintensität erreicht ist und die Brennebene an dieser Position fixiert wird.

9. Verfahren nach einem der Ansprüche 1-8, wobei der Ladungsteilchenstrahl während der Messung des Lichtsignals einen Bereich auf der Probe oder dem Substrat abtastet und das Lichtsignal als integrierter Wert über die Abtastung des Bereichs aufgenommen wird.

10. Verfahren nach einem der Ansprüche 1-8, wobei der Ladungsteilchenstrahl in einer stationären Position in Bezug auf die Probe und/oder das Substrat gehalten wird, und wobei der Ladungsteilchenstrahl im Wesentlichen auf die Probe oder das Substrat fokussiert wird oder wobei der Ladungsteilchenstrahl nicht auf die Probe oder das Substrat fokussiert wird.

11. Verfahren nach Anspruch 2 oder einem der Ansprüche 3 bis 10, wenn von Anspruch 2 abhängig, wobei mindestens die niedrigere Energie des Ladungsteilchenstrahls in einem Bereich von 0 bis 5 keV, vorzugsweise 2 keV oder weniger, liegt.

12. Verfahren nach einem der Ansprüche 1-11, wobei die Verfahrensschritte für mindestens drei Punkte um einen Bereich von Interesse auf der Probe und/oder dem Substrat wiederholt werden, und wobei die Brennebenenpositionen für diese drei Punkte gespeichert und verarbeitet werden, um die Brennebenenposition in dem genannten Bereich von Interesse zu bestimmen.

13. Vorrichtung mit einem lichtbildgebenden Gerät und einem Ladungsteilchengerät (2), wobei das Ladungsteilchengerät angeordnet ist zum Projizieren eines Ladungsteilchenstrahls auf eine Probe und/oder ein Substrat (5), auf dem die Probe befestigt werden kann, wobei die Probe oder das Substrat bei Bestrahlung mit den Ladungsteilchen Licht emittiert, und wobei das lichtbildgebende Gerät zum Abbilden des von der Probe oder dem Substrat emittierten Lichts angeordnet ist, wobei die Vorrichtung ein Positionierungssystem (9) umfasst, das zum Positionieren einer Brennebene (8) des lichtbildgebenden Geräts in Bezug auf die Probe und/oder das Substrat angeordnet ist, und wobei das Positionierungssystem eine Steuervorrichtung (10) umfasst, die ein Positionierungscomputerprogramm umfasst, das Anweisungen zum Positionieren der Brennebene des lichtbildgebenden Geräts an der Oberfläche der Probe oder dem Substrat unter Verwendung eines Verfahrens nach einem der vorhergehenden Ansprüche umfasst.

14. Computerprogramm umfassend Anweisungen, die, wenn sie in die Vorrichtung nach Anspruch 13 geladen werden, die Vorrichtung veranlassen, ein Verfahren nach einem der Ansprüche 1 bis 12 durchzuführen.

15. Computerlesbares Medium, auf dem ein Computerprogramm nach Anspruch 14 aufgezeichnet ist.

## Revendications

1. Procédé pour positionner un plan focal d'un dispositif d'imagerie de lumière au niveau d'une surface d'un échantillon ou d'un substrat sur lequel l'échantillon peut être monté, dans lequel l'échantillon ou le substrat émet de la lumière lorsqu'il est exposé à des particules chargées, le procédé comprenant les étapes consistant à :
i. créer un signal lumineux détectable avec le dispositif d'imagerie de lumière en éclairant l'échantillon et/ou le substrat avec un faisceau de particules chargées ayant une énergie de faisceau de particules chargées réglée ;
ii. déplacer le plan focal du dispositif d'imagerie de lumière au moins dans une direction allant vers l'échantillon et/ou le substrat ou s'éloignant de celui-ci et mesurer une intensité du signal lumineux en fonction de la position dudit plan focal par rapport à l'échantillon et/ou substrat ;
iii. régler le plan focal à une position focale par rapport à l'échantillon et/ou au substrat, ladite position focale étant déterminée à l'aide de la dépendance mesurée de l'intensité du signal lumineux en fonction de la position dudit plan focal par rapport à l'échantillon et/ou substrat à l'aide de l'énergie de particules chargées réglée,
**caractérisé en ce que** la position focale est établie espacée à une distance prédéterminée dans la direction allant vers l'échantillon et/ou substrat ou s'éloignant de celui-ci, par rapport à la position où un signal maximal de l'intensité lumineuse est mesuré.

2. Procédé selon le préambule de la revendication 1, **caractérisé en ce que** le procédé comprend en outre les étapes consistant à :
iv. diminuer l'énergie de faisceau de particules chargées à une énergie de faisceau de particules chargées plus faible, tout en maintenant le plan focal à la position focale;
v. déplacer le plan focal du dispositif d'imagerie de lumière au moins dans une direction allant vers l'échantillon et/ou substrat ou s'éloignant de celui-ci et mesurer l'intensité du signal lumineux en fonction de la position dudit plan focal par rapport à l'échantillon et/ou substrat ; et
vi. utiliser la dépendance mesurée de l'intensité du signal lumineux en fonction de la position dudit plan focal par rapport à l'échantillon et/ou substrat à ladite énergie de faisceau de particules chargées plus faible pour déterminer une nouvelle position focale, et lorsqu'une différence entre cette nouvelle position focale et la position focale est plus grande qu'une valeur seuil, et que la nouvelle position focale est espacée à une distance dans la direction allant vers l'échantillon et/ou substrat ou s'éloignant de celui-ci par rapport à la position focale, la position focale est ajustée sur la nouvelle position focale.

3. Procédé selon la revendication 2, dans lequel les étapes iv, v et vi sont répétées jusqu'à ce que la différence entre la nouvelle position focale et la position focale soit inférieure ou égale à la valeur seuil.

4. Procédé selon la revendication 2 ou 3, dans lequel la position focale est établie à la position où un signal maximum de l'intensité lumineuse est mesuré.

5. Procédé selon la revendication 2 ou 3, dans lequel la position focale est établie à une distance dans la direction allant vers l'échantillon et/ou substrat ou s'éloignant de celui-ci, par rapport à la position où un signal maximum de l'intensité lumineuse est mesuré.

6. Procédé selon la revendication 1, dans lequel ladite distance prédéterminée est une fonction de l'énergie de faisceau de particules chargées réglée.

7. Procédé selon la revendication 1, 5 ou 6, dans lequel la position focale est établie à ladite distance prédéterminée en translatant le plan focal d'une distance de translation depuis la position où un signal maximum de l'intensité lumineuse est mesuré, de préférence dans lequel la direction dans laquelle le plan focal est translaté est déterminée sur la base de l'intensité mesurée du signal lumineux en fonction de la position dudit plan focal par rapport à l'échantillon et/ou substrat.

8. Procédé selon la revendication 2 ou 3, dans lequel le plan focal du dispositif d'imagerie de lumière est ajusté tout en surveillant l'intensité du signal lumineux jusqu'à ce qu'une certaine valeur de l'intensité lumineuse soit atteinte et que le plan focal soit immobilisé à cette position.

9. Procédé selon l'une quelconque des revendications 1-8, dans lequel le faisceau de particules chargées balaie une zone sur l'échantillon ou le substrat durant la mesure du signal lumineux, et le signal lumineux est pris comme valeur intégrée sur le balayage de la zone.

10. Procédé selon l'une quelconque des revendications 1-8, dans lequel le faisceau de particules chargées est maintenu à une position fixe par rapport à l'échantillon et/ou au substrat, et dans lequel le faisceau de particules chargées est sensiblement concentré sur l'échantillon ou le substrat ou dans lequel le faisceau de particules chargées n'est pas concentré au niveau de l'échantillon ou du substrat.

11. Procédé selon la revendication 2 ou l'une quelconque des revendications 3-10 lorsqu'elle dépend de la revendication 2, dans lequel au moins l'énergie de faisceau de particules chargées plus faible est dans une plage de 0-5 keV, de préférence 2 keV ou moins.

12. Procédé selon l'une quelconque des revendications 1-11, dans lequel les étapes de procédé sont répétées pour au moins trois points autour d'une région d'intérêt sur l'échantillon et/ou le substrat, et moyennant quoi les positions de plan focal pour ces trois points sont stockées et traitées afin de déterminer la position de plan focal au niveau de la région d'intérêt citée.

13. Appareil comprenant un dispositif d'imagerie de lumière (1) et un dispositif à particules chargées (2), dans lequel le dispositif à particules chargées est conçu pour projeter un faisceau de particules chargées sur un échantillon (4) et/ou un substrat (5) sur lequel l'échantillon peut être monté, dans lequel l'échantillon ou le substrat émet de la lumière lorsqu'il est exposé auxdites particules chargées, et dans lequel le dispositif d'imagerie de lumière est conçu pour imager ladite lumière émise depuis l'échantillon ou le substrat, dans lequel l'appareil comprend un système de positionnement (9) qui est conçu pour positionner un plan focal (8) du dispositif d'imagerie de lumière par rapport à l'échantillon et/ou au substrat, et dans lequel le système de positionnement comprend un dispositif de commande (10) qui comprend un programme informatique comprenant des instructions pour positionner le plan focal du dispositif d'imagerie de lumière au niveau de la surface de l'échantillon ou du substrat à l'aide d'un procédé selon l'une quelconque des revendications précédentes.

14. Programme informatique comprenant des instructions qui, lorsqu'elles sont chargées sur l'appareil selon la revendication 13, amèneront ledit appareil à effectuer un procédé selon l'une quelconque des revendications 1 à 12.

15. Support lisible sur ordinateur, comportant un programme informatique selon la revendication 14 enregistré sur celui-ci.
